# EUROPÄISCHE PATENTSCHRIFT

(11) **EP 1 671 923 B1**
(45) Veröffentlichungstag und Bekanntmachung des Hinweises auf die Patenterteilung: **06.02.2008**
(21) Anmeldenummer: 06110976.5
(22) Anmeldetag: 27.10.2001
(51) Int. Cl.: B81B 7/00

(54) **Mikromechanisches Bauelement sowie ein Verfahren zur Herstellung eines mikromechanischen Bauelements**
Micromechanical device and method of manufacturing a micromechanical device
Dispositif micromécanique et procédé de fabrication d'un dispositif micromécanique

(30) Priorität: 03.02.2001 DE 10104868
(43) Veröffentlichungstag der Anmeldung: 21.06.2006
(62) Teilanmeldung aus: 01125720.1
(73) Patentinhaber: ROBERT BOSCH GMBH, 70442 Stuttgart (DE)
(72) Erfinder: Fischer, Frank, 72810, Gomaringen (DE); Hein, Peter, 72770, Reutlingen (DE); Graf, Eckhard, 72810, Gomaringen (DE)

(56) Entgegenhaltungen:
- EP-A- 1 057 779
- DE-C1- 19 931 773
- US-A- 4 773 972

## Beschreibung

### Stand der Technik

Die Erfindung geht aus von einem mikromechanischen Bauelement und einem Verfahren zur Herstellung eines mikromechanischen Bauelements nach der Gattung der betreffenden unabhängigen Patentansprüche. In der DE 195 37 814 A1 wird der Aufbau eines Sensor-Schichtsystems und ein Verfahren zur hermetischen Verkappung von Sensoren in Oberflächenmikromechanik beschrieben.

Die europäische Patentanmeldung EP 1 057 779 A2 offenbart eine Flip-Chip-Anordnung für mikrobearbeitete Halbleiter mit drei Funktionsschichten. Die Flip-Chip-Anordnung weist eine Anzahl Durchkontaktierungen auf, welche sich von der Oberseite zur Unterseite erstrecken. Die Anordnung weist weiterhin eine Kavität und ein Substrat auf. Die Patentschrift US 4 773 972 offenbart einen mikromechanischen Drucksensor mit einer Kappe, einer Funktionsschicht und einem Substrat. Der Drucksensor weist Durchkontaktierungen auf, welche sich durch das Substrat hindurch zur Funktionsschicht erstrecken. Die Patentschrift DE 199 31 773 C1 zeigt ebenfalls ein mikromechanisches Bauelement mit Kontaktdurchführungen. Das Bauelement weist einen Glaswafer auf, der mit einem Siliziumwafer verbunden ist. Eine Ausnehmung im Siliziumwafer bildet einen Innenraum. Der Glaswafer weist Kontaktdurchführungen auf, welche Funktionselemente im Innenraum elektrisch kontaktieren.

### Vorteile der Erfindung

Das erfindungsgemäße Bauelement sowie das erfindungsgemäße Verfahren mit den kennzeichnenden Merkmalen der betreffenden unabhängigen Patentansprüche hat demgegenüber insbesondere den Vorteil, daß ein kompaktes und langzeitstabiles Bauelement kostengünstiger hergestellt werden kann. Durch die in den abhängigen Patentansprüchen aufgeführten Maßnahmen sind vorteilhafte Weiterbildungen und Verbesserungen des Bauelements und des Verfahrens nach den betreffenden unabhängigen Patentansprüchen ermöglicht.

Das erfindungsgemäße Bauelement zeichnet sich gegenüber bekannten Bauelementen durch einen robusten Schichtaufbau und durch eine deutliche Reduzierung der für das Verkappen benö-tigten Fläche aus, was aufgrund der Flächeneinsparung mit einer signifikanten Kostenreduzierung einhergeht.

Ein wesentlicher Aspekt der Erfindung besteht darin, daß eine Kappe die Funktionsstrukturen überdeckt, wobei die Kappe mit der strukturierten Schicht mittels eines anodisch bondbaren Glases bzw. eines Bondglases verbunden ist. Bevorzugt weist die durch das anodisch bondbare Glas erfindungsgemäß gebildete Verbindungsschicht eine Dicke im Bereich von 300 nm bis 100 µm, insbesondere eine Dicke im Bereich von 300 nm bis 50 µm, auf. Durch das anodisch bondbare Glas lässt sich in einfacher Weise eine mechanisch sehr stabile Verbindung zwischen der Kappe und der strukturierten Schicht bei gegenüber dem Stand der Technik deutlich verringerter Verbindungsfläche herstellen. Bei einer Massenfertigung, bei der das erfindungsgemäße mikromechanische Bauelement mehr als tausendfach auf einem Wafer bzw. Substrat gebildet wird, ergibt sich demzufolge eine ganz erhebliche Flächeneinsparung bzw. erheblich verbesserte Ausnutzung eines Wafers.

Indem erfindungsgemäß bevorzugt ein anodisch bondbares Glas mit einer Dicke im Bereich von 300 nm bis 100 µm gewählt oder eigens aus einem dickeren Glas-Wafer hergestellt wird, lassen sich die erfindungsgemäß auf einem Wafer gebildeten mikromechanischen Bauelemente mit jeweils einem einzigen Sägeschnitt durch den gesamten Schichtaufbau des mikromechanischen Bauelements vereinzeln. Dies ist möglich, weil ein herkömmliches Sägeblatt zum Aussägen der mikromechanischen Bauelemente aus dem Wafer auch das anodisch bondbare Glas der genannten Dicke ohne Beschädigung des Sägeblatts oder des Bauelements durchtrennen kann. Beim Stand der Technik war es bisher notwendig mit einem ersten Sägeblatt einen Sägeschnitt bis zur Verbindungsschicht vorzunehmen, mit einem zweiten Sägeblatt die Verbindungsschicht zu durchtrennen und nachfolgend erneut mit dem ersten Sägeblatt das mikromechanische Bauelement vollständig zu durchtrennen bzw. zu vereinzeln.

Bei einer bevorzugten Ausführungsform der Erfindung wird ein Bondglas verwendet, das über eine definierte Ionenkonzentration verfügt, um dieses anodisch bonden zu können, was nachfolgend näher erläutert werden wird. Als Bondgläser haben sich insbesondere Gläser bewährt, die Alkalisilikat und/oder Borsilikat aufweisen.

Ein weiterer wesentlicher Aspekt der Erfindung besteht darin, in dem Substrat des mikromechanischen Bauelements einen Anschlussbereich zur externen Kontaktierung der Funktionsstrukturen vorzusehen. Bevorzugt wird der Anschlussbereich durch einen durch Gräben gebildeten Isolationsrahmen gegenüber dem Substrat elektrisch isoliert. Der Anschlussbereich kann unmittelbar neben oder auch unter einem Stützelement in dem Substrat vorgesehen sein, um die für das mikromechanische Bauelement erforderliche Substratfläche bzw. dessen Volumen, insbesondere aus Kostengründen, zu minimieren.

Bekannt ist die externe Kontaktierung der Funktionsstrukturen über eine in der Kappe vorgesehene trichterförmige Öffnung, die sich von den Funktionsstrukturen weg ausdehnt. An einer solchen externen Kontaktierung ist insbesondere von Nachteil, daß der beim Sägen bzw. Vereinzeln der mikromechanischen Bauelemente aus dem Wafer entstehende Sägeschlamm in die trichterförmige Zugangsöffnung gelangt. Die trichterförmige Zugangsöffnung in der Kappe lässt sich nur mit erheblichem Aufwand von dem Sägeschlamm reinigen. Nicht ausgewaschene Reste des Sägeschlamms führen zu Nebenschlüssen, was zu einem Ausfall des betreffenden mikromechanischen Bauelements führen kann.
Indem der Anschlussbereich zur externen Kontaktierung der Funktionsstrukturen in erfindungsgemäße Weise in dem Substrat geschaffen wird, lässt sich insbesondere bei einer Substratdicke im Bereich von ca. 80 µm bis 150 µm, vorzugsweise ca. 80 µm bis 100 µm, das Verfahren des Plasmaätzens bzw. Trenchätzens verwenden. Hiermit können schmale, tiefe Gräben zur Bildung eines Isolationsrahmens hergestellt werden, die sich weitgehend senkrecht von der Substratunterseite bis zur Funktionsschicht erstrecken. Die Wahl der Dicke des Substrats wird sich insbesondere an der erforderlichen mechanischen Stabilität des mikromechanischen Bauelements und an der maximal möglichen Tiefe der Gräben orientieren, bis zu der schmale Gräben, z.B. durch Trenchätzen, hergestellt werden können. Diese Gräben bzw. der durch die Gräben gebildete Isolationsrahmen wird erfindungsgemäß mit einem Dielektrikum im Bereich der Substratunterseite verschlossen, das den Anschlussbereich, der einen Teil des Substrats bildet, gegenüber dem Substrat elektrisch isoliert.

Einen anderer wesentlicher Aspekt der Erfindung besteht darin, durch Ätzen ein Sackloch zu bilden, das weitgehend senkrecht durch das Substrat, die strukturierte Schicht, und die Verbindungsschicht bis zur Kappe verläuft, wobei der Boden des Sacklochs im Bereich der Kappe und die Öffnung des Sacklochs an der Seite des Substrats vorgesehen ist, die von den Funktionsstrukturen abgewandt ist. Bevorzugt wird das Sackloch bzw. der Durchgang auf seiner Bodenfläche und an seinen Wandflächen mit einer Leitschicht versehen, so daß eine elektrische Verbindung zwischen der Kappe, der strukturierten Schicht und dem Substrat gegeben ist. Bevorzugt wird das Sackloch bzw. der Durchgang nach der Herstellung der Leitschicht vollständig mit einer Füllschicht aufgefüllt. Indem die Leitschicht erfindungsgemäß auf ein definiertes elektrisches Potential gelegt wird, vorzugsweise Masse, werden Potentialunterschiede zwischen der Kappe, der strukturierten Schicht und dem Substrat und damit potentielle Störspannungen vermieden.

Falls die mechanische Stabilität des erfindungsgemäßen mikromechanischen Bauelements unzureichend ist, kann zwischen dem Substrat und der Kappe mindestens ein Stützelement vorgesehen werden, wobei das Stützelement vorzugsweise durch Ätzen der Funktionsschicht, vorzugsweise weitgehend in der Mitte des von der Kappe abgedeckten Hohlraums, gebildet wird.

Ein weiterer wesentlicher Aspekt der Erfindung besteht in der Verwendung eines Verfahrens zur Herstellung eines mikromechanischen Bauelements bei der die strukturierte Schicht, die Funktionsstrukturen aufweist, mit einer Kappe über einer Verbindungsschicht verbunden wird. Das Material der Verbindungsschicht wird bevorzugt derart gewählt, daß durch das Anlegen einer elektrischen Spannung zwischen dem Substrat und der Kappe des mikromechanischen Bauelements eine chemische Verbindung sowohl zwischen der Verbindungsschicht und der strukturierten Schicht als auch zwischen der Verbindungsschicht und der Kappe, vorzugsweise insbesondere im Randbereich des zwischen der Kappe und den Funktionsstrukturen gebildeten Hohlraums, herbeigeführt wird (anodisches Bonden). Bevorzugt wird hierbei zumindest der Verbindungsbereich erwärmt. Die Verbindung zwischen der Kappe und der der Kappe zugewandten Seite der Verbindungsschicht erfolgt bevorzugt in einem ersten Schritt und die Verbindung zwischen der der strukturierten Schicht und der der strukturierten Schicht zugewandten Seite der Verbindungsschicht erfolgt in einem separaten, zweiten Schritt.

Bevorzugt werden die Verbindungsstellen vor dem anodischen Bonden chemisch und/oder mechanisch so vorbehandelt, daß sie eine geringe Oberflächenrauheit aufweisen, die vorzugsweise etwa 40 nm oder weniger beträgt.
Schließlich zeichnet sich das erfindungsgemäße Bauelement durch eine niedrige Topographie aus, wodurch beispielsweise der Einsatz der so genannten Flip-Chip-Technik bei der Montage des Bauelements ermöglicht wird.

### Zeichnungen

Die Erfindung wird nachfolgend anhand von nicht notwendigerweise maßstäblichen Zeichnungen näher erläutert, wobei gleiche Bezugszeichen gleiche oder gleichwirkende Schichten oder Teile bezeichnen. Es zeigen:
- Fig. 1: einen Querschnitt eines erfindungsgemäßen Bauelements mit einem Substrat, einer strukturierten Schicht und einer Kappe; und
- Fig. 2 - 10: ein erfindungsgemäßes Verfahren zur Herstellung des in Fig. 1 dargestellten Bauelements.

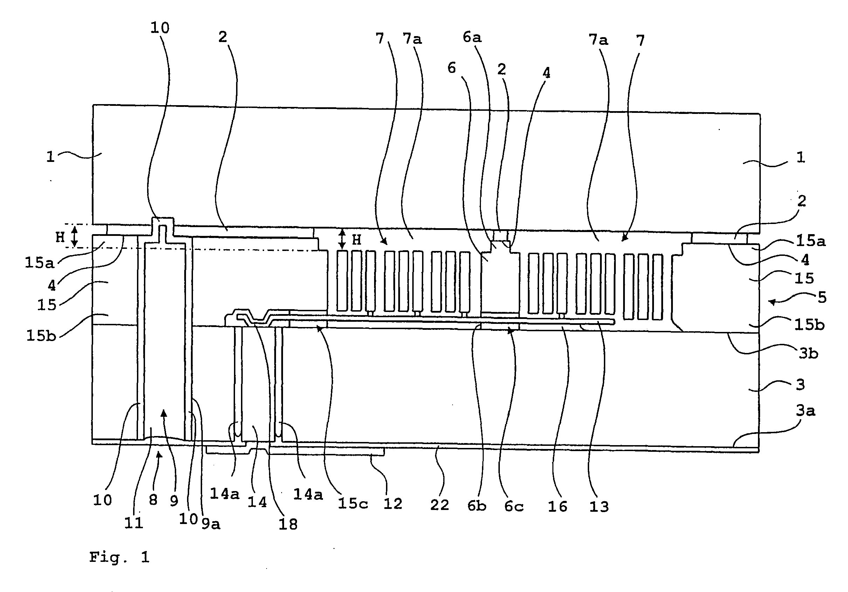

In Fig. 1 ist ein Bauelement, beispielsweise ein Beschleunigungssensor, im Querschnitt gezeigt. Auf einem Substrat 3 ist eine strukturierte Schicht 5 angeordnet, in der Funktionsstrukturen 7 und Stützstrukturen gebildet sind. Die Funktionsstrukturen 7 sind in dem konkreten Ausführungsbeispiel in der strukturierten Schicht 5 als ineinander greifende Kämme bzw. Interdigitalstrukturen mit feststehenden und ausgelenkbaren Elektroden ausgebildet. Die Stützstrukturen werden durch einen Rahmen 15, der die Funktionsstrukturen 7 umgibt, und ein Stützelement 6 gebildet, das innerhalb des Rahmens 15 im Bereich der Funktionsstrukturen 7 angeordnet ist und zur mechanischen Stabilität des Schichtsystems beiträgt. In dem konkreten Ausführungsbeispiel der Fig. 1 ist lediglich ein Stützelement 6 dargestellt, das zwischen den beiden gezeigten Funktionsstrukturen 7 angeordnet ist. In Abhängigkeit von der erforderlichen mechanischen Stabilität des Bauelements kann jedoch auch kein Stützelement, ein einziges Stützelement 6 oder mehrere, voneinander beabstandete Stützelemente im Bereich der Funktionsstrukturen vorgesehen sein. Zweckmäßigerweise werden das Stützelement oder die Stützelemente so angeordnet, daß die Bewegungsfreiheit der Funktionsstrukturen 7 nicht beeinträchtigt ist.

Eine etwa planflächige Kappe 1 ist über eine Verbindungsschicht 2 mit den Stützstrukturen 6 und 15 der strukturierten Schicht 5 verbunden und überdeckt die Funktionsstrukturen 7.

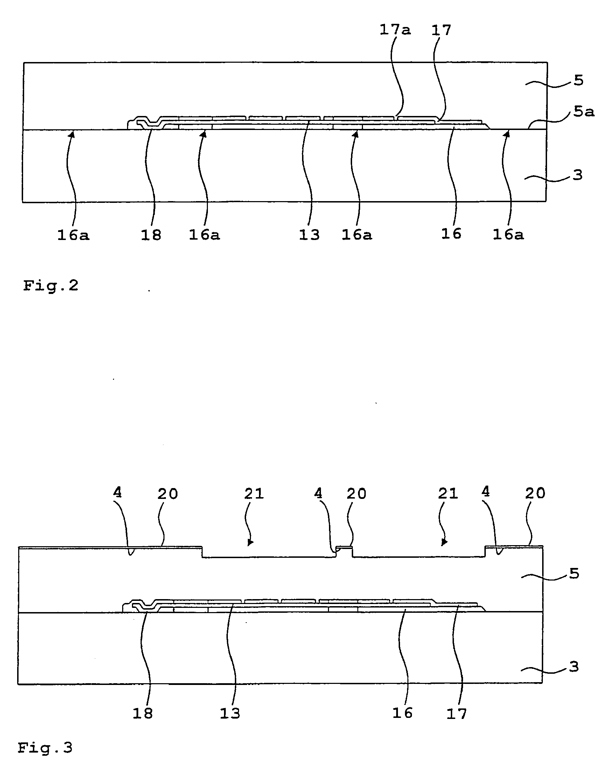

Die Stützstrukturen 6 und 15 sind im Vergleich zu den Funktionsstrukturen 7 erhöht ausgebildet (vgl. Fig. 3) und überragen die Funktionsstrukturen 7 vorzugsweise um etwa 4 - 10 µm, so daß sich Hohlräume 7a im Bereich der Funktionsstrukturen 7 ausbilden bzw. zwischen den Funktionsstrukturen 7 und der Kappe 1 aufspannen.

Alternativ oder ergänzend kann auf der Unterseite der Kappe, d.h. auf der Seite der Kappe, die den Funktionsstrukturen 7 zugewandt ist, eine Vertiefung im Bereich der Funktionsstrukturen vorgesehen werden, so daß die Vertiefung den Hohlraum bzw. die Hohlräume 7a über den Funktionsstrukturen 7 ganz oder teilweise bildet (nicht dargestellt).

Die Verbindungsschicht 2 ist im Bereich der Funktionsstrukturen 7 entfernt, so daß sich die Spannhöhe H der Hohlräume 7a entsprechend vergrößert. Zweckmäßigerweise ist die Spannhöhe H der Hohlräume 7a stets dergestalt, daß eine zerstörende Auslenkung der Funktionsstrukturen 7 in vertikaler Richtung, d. h der z-Richtung, unterbunden ist. Die Gesamtspannweite der Hohlräume 7a in lateraler Richtung liegt bevorzugt zwischen etwa 100 und 500 µm. Spannweiten bis zu mehreren mm sind jedoch ebenfalls möglich.

An ersten, der Kappe 1 zugeordneten Enden 6a und 15a des Stützelements 6 und des Rahmens 15 sind Verbindungsflächen 4 zur Verbindung mit der Verbindungsschicht 2 gebildet. Die Verbindungsflächen 4 weisen eine Breite von weniger als 150 µm und eine hohe Oberflächengüte bzw. eine niedrige Oberflächenrauheit auf, die vorzugsweise etwa 40 nm oder weniger beträgt. Das Stützelement 6 und der Rahmen 15 sind mit ihren zweiten Enden 6b und 15b mit dem Substrat 3 verbunden.

Zwischen dem Substrat 3 und der strukturierten Schicht 5 sind Leiterbahnen 13 vorgesehen, die zur externen Kontaktierung der Funktionsstrukturen 7 dienen. Die Leiterbahnen 13 sind im nahen Bereich unterhalb der Funktionsstrukturen 7 platziert und verlaufen durch Durchführungen 6c und 15c der Stützstrukturen 6 und 15, wobei zwei Opferschichten 16 und 17 (siehe Fig. 2) die Leiterbahnen 13 gegenüber den Stützstrukturen 6 und 15 isolieren.

Zur externen Kontaktierung der Funktionsstrukturen 7 ist zudem im Substrat 3 ein Anschlussbereich 14, weitgehend unmittelbar neben den Funktionsstrukturen 7, gebildet, der an der der strukturierten Schicht 5 zugewandten Oberseite 3b des Substrats 3 in unmittelbarem Kontakt zu einer Kontaktzunge 18 der Leiterbahnen 13 steht. Der Anschlussbereich 14 ist vollständig von Gräben 14a umgeben, die einen Isolationsrahmen bilden. Die Gräben 14a erstrecken sich von der Substratunterseite bis zur Substratoberseite, so daß der hierdurch gebildete Anschlussbereich 14 gegenüber dem Substrat 3 elektrisch isoliert ist. Die Gräben 14a weisen bevorzugt ein hohes Aspektverhältnis, d.h. eine große Tiefe und eine geringe laterale Abmessung, auf. Auf dem Anschlussbereich 14 ist an seiner der strukturierten Schicht 5 abgewandten Rückseite 3a des Substrats 3 eine Metallisierung 12 aufgebracht, die bevorzugt eine Leiterbahn und ein Kontaktpad zur Befestigung von Bonddrähten bildet, über die eine externe elektrische Verbindung zu den Funktionsstrukturen 7 hergestellt wird. Die Metallisierung 12 ist an der Rückseite 3a des Substrats 3 durch eine dielektrische Schicht 22 gegenüber dem Substrat 3 isoliert.

Die Metallisierung 12 und damit die Leiterbahn und das Kontaktpad erstrecken sich bevorzugt vom Anschlussbereich 14 horizontal in Richtung der Funktionsstrukturen 7, wodurch die für die Herstellung des Bauelements erforderliche Wafer- bzw. Substratfläche in Kosten sparender Weise verringert werden kann.

Bei einer bevorzugten Ausführungsform (nicht dargestellt) ist der Anschlussbereich 14 zur externen Kontaktierung der Funktionsstrukturen 7 weitgehend mittig unter dem Stützelement 6 hergestellt. Dies führt zu einer Flächeneinsparung der für die Herstellung des Bauelements benötigten Wafer- bzw. Substratfläche, was mit einer Kosten sparenden Verringerung des Volumens des Bauelements einhergeht. Die Packungsdichte wird erhöht.

Des weiteren ist zwischen dem Substrat 3, der strukturierten Schicht 5 und der Kappe 1 eine leitende Verbindung 8 vorgesehen, um Potentialunterschiede zwischen dem Substrat 3 und der Kappe 1 zu vermeiden. Die leitende Verbindung 8 umfasst ein Sackloch bzw. einen Durchgang 9, der sich außerhalb des Bereichs der Leiterbahnen 13 durch das Substrat 3, den Rahmen 15 und in einen Teil der Kappe 1 hinein erstreckt. Eine Leitschicht 10, insbesondere eine Metallschicht, die auf dem Boden und den Wandflächen 9a des Durchgangs 9 aufgebracht ist, verbindet das Substrat 3, die strukturierte Schicht 5 und die Kappe 1. Eine Füllschicht 11 verschließt den Durchgang 9 an der Rückseite 3a des Substrats 3 und ebnet die Topographie ein.

Anhand der Fig. 2 bis 10 ist nachfolgend eine mögliche Prozessfolge zur Herstellung des in Fig. 1 dargestellten Bauelements im Detail beschrieben. In Fig. 2 ist der Schichtaufbau des Bauelements gezeigt, wie er sich vor einer Tiefenstrukturierung der strukturierten Schicht 5 darstellt. Auf dem Substrat 3, das bevorzugt aus einkristallinem Silizium hergestellt ist, ist eine erste Opferschicht 16 aufgebracht, die beispielsweise aus einer oder mehreren SiO₂- Schichten bestehen kann. Auf der ersten Opferschicht 16 sind Leiterbahnen 13 abgeschieden, die aus polykristallinem Silizium bestehen, das zwecks einer möglichst großen Leitfähigkeit ausreichend stark dotiert ist. Die erste Opferschicht 16 wird vor dem Aufbringen der Leiterbahnen 13 vorstrukturiert, wobei in die erste Opferschicht 16 eine Kontaktöffnung für die entsprechend geformte Kontaktzunge 18 für jede der Leiterbahnen 13 geätzt wird. Jede der Kontaktzungen 18 grenzt unmittelbar an das Substrat 3 an und steht in direkter Verbindung mit dem später jeweils im Substrat 3 gebildeten Anschlussbereich 14. Die beschriebene Herstellung der Anschlussbereiche und deren jeweilige externe Kontaktierung (nicht dargestellt) erfolgt in gleicher Weise wie die Herstellung und externe Kontaktierung des explizit dargestellten Anschlussbereichs 14.

Auf den Leiterbahnen 13 ist eine zweite Opferschicht 17 abgeschieden, die wie die erste Opferschicht 16 als Isolationsschicht dient und aus SiO₂ besteht. Bevorzugte Abscheideverfahren zur Erzeugung der zweiten Opferschicht 17 sind CVD-Verfahren, wie unter Verwendung von Tetra-Ethyl-Ortho-Silicat (TEOS). Auf der zweiten Opferschicht 17 wird dann eine dünne Start-Poly-Silizium-Schicht 5a, d.h. eine polykristalline Siliziumschicht mit der Funktion einer Keim- bzw. Nukleationsschicht, abgeschieden. Auf die Start-Poly-Si-Schicht 5a wird mit einem Epitaxie-Verfahren eine polykristalline Silizium-schicht, welche die nachfolgend gebildete strukturierte Schicht 5 darstellt, aufgebracht, wobei die Start-Poly-Si-Schicht in der oberen polykristallinen Schicht aufgeht. Die Oberfläche der oberen polykristallinen Schicht 5 wird in einem weiteren Prozessschritt planarisiert. Dies geschieht durch einen chemisch-mechanischen Polierprozess (CMP), mit dem eine Oberflächenrauheit erreicht wird, bei der die Oberflächen sich gut mit der Verbindungsschicht 2 durch Anlegen einer Differenzspannung verbinden bzw. anodisch bonden lassen. Die Oberflächenrauheit beträgt hierzu vorzugsweise ca. 2 nm bis ca. 50 nm.

Die Opferschichten 16 und 17 werden zweckmäßigerweise vor dem Abscheiden der Start-Poly-Si-Schicht 5a strukturiert. Dabei werden die erste und die zweite Opferschicht 16 und 17 in Bereichen 16a, in denen in einem späteren Prozessschritt die Stützstrukturen 6 und 15 gebildet werden, teilweise oder vollständig entfernt, so daß die Stützstrukturen 6 und 15 direkt mit dem Substrat verbunden sind. In der zweiten Opferschicht 17 werden Kontaktöffnungen 17a zur Kontaktierung der Funktionsstrukturen 7 mit den Leiterbahnen 13 gebildet.

Wie in Fig. 3 dargestellt ist, wird mit einem CVD-Verfahren eine Oxidmaske 20 auf die Verbindungsflächen 4 aufgebracht, wobei sich die Verbindungsflächen 4 im Bereich der später gebildeten Stützstrukturen 6 und 15 befinden. Die aus der Gasphase abgeschiedene Oxidmaske 20 dient aufgrund ihrer guten Si/SiO₂ Selektivität als Passivierschicht und gewährleistet, daß die Verbindungsflächen 4 bei einem späteren Plasma-Ätzschritt oder chemisch-mechanischen Polierprozess (CMP) nicht angegriffen werden. Mit einem Trockenätzverfahren oder mit einem weiteren CMP-Schritt werden in Bereichen 7 der strukturierten Schicht 5, in denen später die Funktionsstrukturen 7 strukturiert werden planflächige Ausnehmungen 21 geätzt oder geformt. Die Oxidmaske 20 wird anschließend entfernt.

Alternativ oder ergänzend (nicht dargestellt) kann bzw. können in der Unterseite der Kappe eine oder mehrere Ausnehmungen zur vollständigen oder teilweisen Bildung des Hohlraums über den Funktionsstrukturen, beispielsweise durch Plasmaätzen, erzeugt werden.

Bei dem oben beschriebenen Prozessschritt werden die Stützstrukturen 6 und 15 in Bezug auf ihre Höhe (und ggf. in Bezug auf ihre Breite) gegenüber den Funktionsstrukturen 7 vorstrukturiert, indem die strukturierte Schicht 5 in den Bereichen der Funktionsstrukturen 7 um einen definierten Betrag abgedünnt wird.

Alternativ wird zur Erhöhung der Stützstrukturen 6 und 15 lediglich die Verbindungsschicht mit einer entsprechend größeren Dickenabmessung verwendet (Fall nicht dargestellt).

Sind in der Unterseite der Kappe eine oder mehrere Ausnehmungen vorgesehen, so kann diese bzw. können diese so strukturiert werden, daß die Ausnehmung bzw. die Ausnehmungen eine oder mehrere Stützelemente aufweist, die zu ein oder mehreren Stützelementen der strukturierten Schicht 5 komplementär sind (nicht dargestellt).

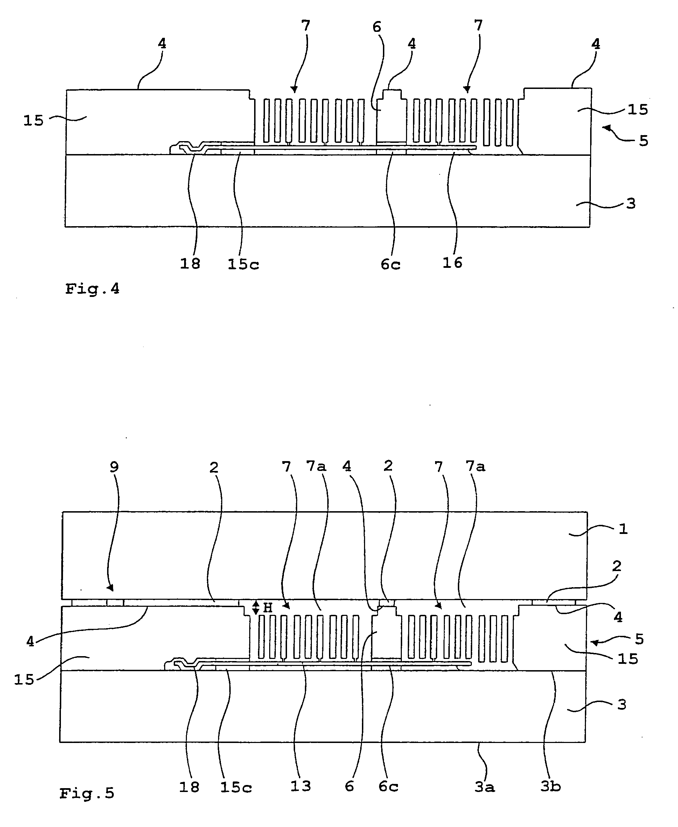

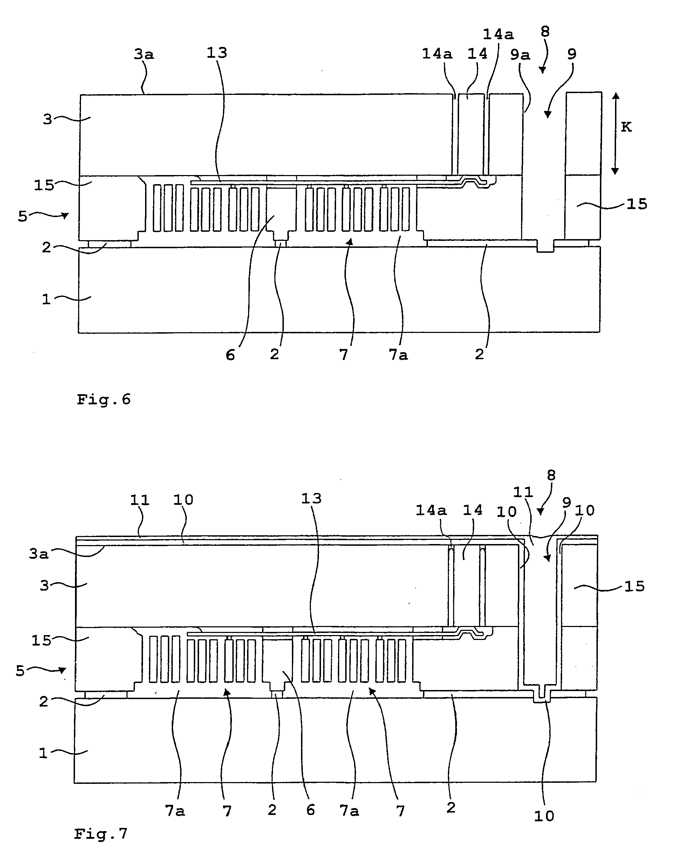

In einem weiteren, in Fig. 4 dargestellten Prozessschritt werden die Funktionsstrukturen 7 und das Stützelement 6 mit einem Tiefenstrukturierungsverfahren (Trench-Ätzen) strukturiert. Die zweite Opferschicht 17 und teilweise auch die erste Opferschicht 16 werden unterhalb von den Funktionsstrukturen 7 mit einem Gasphasenätzverfahren entfernt, so daß auslenkbare Strukturen entstehen.
In einem zentralen Schritt erfolgt die hermetisch dichte Verkappung des Bauelement- bzw. Sensor-Schichtsystems, wie in Fig. 5 gezeigt ist. Hierbei wird, wie nachfolgend detailliert beschrieben ist, die Kappe 1, die aus einkristallinem Silizium besteht, mit den Verbindungsflächen 4 der Stützstrukturen 6 und 15 über die Verbindungsschicht 2 chemisch verbunden.

Die Verbindungsschicht 2 besteht aus einem etwa 10 - 50 µm dicken Silikatglas, das vorzugsweise durch chemische und/oder mechanische Behandlung aus einem dickeren, z. B. 500 µm dicken, Silikatglas-Wafer hergestellt wird. Das Silikatglas weist eine definierte Konzentration an ein- oder mehrwertigen Kationen, wie Na⁺ oder B³⁺, und eine entsprechende Konzentration an schwachgebundenen Sauerstoffatomen aufweist. Besonders geeignete Silikate sind Alkali- und Borsilikate.

Um eine hohe Oberflächengüte zwecks optimaler Fügeverbindung zwischen der Kappe 1 und der Verbindungsschicht 2 herstellen zu können, wird die Kappe 1 an der der Verbindungsschicht 2 zugewandten Seite chemisch-mechanisch poliert. Die Oberflächenrauheit beträgt nach dem CMP-Schritt typischerweise unter 2 nm. Dann wird die Kappe 1 mit der Verbindungsschicht 2 durch Anlegen einer Spannungsdifferenz zwischen der Kappe und der Verbindungsschicht 2, typischerweise ca. - 150 bis - 1000 V, wobei die Kappe 1 an Masse liegt, flächig verbunden.

Zusätzlich kann während des Verbindungsschritts eine erhöhte Temperatur von etwa 350 - 450 °C auf die Verbindungsschicht 2 einwirken, um die Beweglichkeit der Metall- oder Bor-Kationen zu erhöhen. Die reduzierte Kationen-Konzentration kann beispielsweise durch eine nachträgliche Temperatureinwirkung ausgeglichen werden. Alternativ oder ergänzend wird die Versorgungsspannung nach dem Verbinden der Kappe 1 mit der Verbindungsschicht 2 umgekehrt, um die entstandene, reduzierte Konzentration der Kationen an der Grenzfläche der Verbindungsschicht 2 zur Kappe 1 auszugleichen.

Alternativ kann die Verbindungsschicht 2 in Form einer Schmelze auf die Kappe 1 aufgebracht werden, wobei die Schmelz- bzw. Erweichungstemperatur je nach Art des verwendeten Silikatglases in einem Bereich von etwa 600 - 800 °C liegt. In diesem Temperaturbereich findet ebenfalls eine chemische Verbindung zwischen der Kappe 1 und der Verbindungsschicht 2 statt. Nach dem Erstarren wird die Verbindungsschicht 2 wie nachfolgend beschrieben bearbeitet.

Nach der Verbindung der Kappe 1 mit der Verbindungsschicht 2 wird die Verbindungsschicht 2 gemäß der vorstehenden ersten oder zweiten Alternativen an der den Verbindungsflächen 4 zugewandten Seite grobmechanisch abgeschliffen bzw. gedünnt und anschließend mit einem CMP-Schritt poliert, um eine gute Fügeverbindung mit den Verbindungsflächen 4 der strukturierten Schicht 5 herzustellen.

Nach dieser Bearbeitung weist die Verbindungsschicht 2 eine Dicke von etwa 10 - 50 µm und eine Oberflächenrauheit von 2 nm oder weniger auf.

Bei einer weiteren bevorzugten Alternative wird die Verbindungsschicht durch Sputtern von Silikatglas, wie insbesondere Elektronenstrahl-Sputtern, aufgebracht. Zuvor wird die Kappe thermisch oxidiert, wodurch eine ca. 1 bis 2 µm dicke Silizium-Oxidschicht gebildet wird, auf der die Verbindungsschicht durch Sputtern abgeschieden wird. Die Silizium-Oxidschicht verbessert die elektrische Spannungsfestigkeit beim anodischen Bonden. Bevorzugte Schichtdicken für eine durch Sputtern gebildete Verbindungsschicht (Alkali- oder Borsilikat) liegen im Bereich von etwa 300nm bis 2 µm.
Die Verbindungsschicht 2 wird allen drei vorgenannten Alternativen im Bereich der Funktionsstrukturen 7 entfernt oder strukturiert, um die Spannhöhe H der Hohlräume 7a zu vergrö-ßern.

Die Verbindungsschicht 2 wird zudem im Bereich des später gebildeten Durchgangs 9 der leitenden Verbindung 8 entfernt.
In einem weiteren Prozessschritt erfolgt das Verbinden der Verbindungsflächen 4 der strukturierten Schicht 5 mit der Verbindungsschicht 2. Die Verbindungsflächen 4 und die Verbindungsschicht 2 werden zueinander justiert und durch die angelegte Versorgungsspannung und/oder unter Temperatureinwirkung chemisch verbunden (anodisches Bonden). Hierzu wird an die Kappe 1 eine im Verhältnis zum Bonden der Kappe 1 mit der Verbindungsschicht 2 geringere Spannung an die Kappe angelegt, um eine übermäßige Auslenkung der Funktionsstrukturen 7 infolge der Bondspannung zu verhindern. Dies können typischerweise - 100 V an der Kappe 1 sein, wobei das Substrat 3 an Masse liegt.

Beim Verkappen wird bevorzugt ein Gas mit einem Druck zwischen ca. 1 mbar und 1 bar in die Hohlräume 7a eingeschlossen, wobei über den Druck die Dämpfung der Bewegung der Funktionsstrukturen 7 festgelegt wird. Ergänzend kann auch nach dem Verkappen über eine verschließbare Öffnung eine Flüssigkeit in die Hohlräume 7a eingebracht werden, wobei deren Viskosität das Maß der Dämpfung bestimmt, oder auch ein Gas oder auch ein weiteres Gas.

Die Grunddotierung des n-dotierten Substrats 3 ist typischerweise größer als ca. 5*10¹⁵/cm³ und der ohmsche Widerstand kleiner als ca. 1 Ohm * cm (niederohmig). Die Dotierung der n-dotierten Funktionsschicht 5 liegt bei etwa 10¹⁷/cm³ bis 10¹⁹/cm³, wodurch ein niederohmiger externer Kontakt mit den Funktionsstrukturen 7 ermöglicht ist.
Mit dem oben beschriebenen anodischen Bondverfahren wird eine hermetisch dichte Verbindung zwischen der Kappe 1 und der Verbindungsschicht 2 einerseits sowie zwischen der Verbindungsschicht 2 und den Verbindungsflächen 4 bzw. der strukturierten Schicht 5 andererseits hergestellt. Ein besonderer Vorteil des obigen Verfahrens besteht darin, daß relativ kleine Verbindungsflächen 4 benötigt werden. Beispielsweise beträgt die Breite der Verbindungsflächen nur etwa 30 bis 150 µm.

Nach dem Verbinden der Kappe 1 mit den Verbindungsflächen 4 erfolgt das mechanische Rückschleifen der Rückseite 3a des Substrats 3 (vgl. Fig. 6). Dies geschieht bevorzugt in mehreren Schritten: Zuerst wird die Rückseite 3a des Substrats 3 mit einer Diamantschleifscheibe großer Körnung grobabrassiv geschliffen und anschließend mit einer Diamantschleifscheibe kleiner Körnung mit entsprechend geringerem Abtrag abgeschliffen. Alternativ kann das Abschleifen auch in einem einzigen Schritt erfolgen. Die Oberflächenrauheit beträgt nach dem Feinschliff etwa 0,1 - 1 µm und die Tiefe von Kristallversetzungen beläuft sich auf etwa 3 - 5 µm.

Mit einem CMP-Prozeß werden die Kristallversetzungen entfernt und die Oberflächengüte weiter verbessert. Der Abtrag beträgt hierbei etwa 10 µm. Alternativ können mittels so genanntem Spin-Etching die Kristallversetzungen im Substrat 3 entfernt werden. Der Abtrag beträgt hierbei typischerweise 5 bis 10 µm.

Nach anschließendem CMP-Planarisieren beträgt der Abtrag dann noch typischerweise 3 µm.

Die Restdicke K des Substrats 3 ist so gewählt, daß die statische Festigkeit des Schichtsystems gewährleistet ist, wobei die Stützelemente 6 die statische Festigkeit erheblich verbessern. Insbesondere bei kleinen Spannweiten kann auf Stützelemente verzichtet werden. Typischerweise ist die Restdicke K des Substrats 3 etwa 80 - 150 µm.

In einem weiteren Prozessschritt, vgl. Fig. 6, werden mit einem Tiefenstrukturierungsverfahren (Trench-Ätzen) Gräben 14a für den Anschlussbereich 14 gebildet. Des weiteren wird der Durchgang 9 durch ein bekanntes Tiefenätzverfahren gebildet, wobei sich der Durchgang 9 durch das Substrat 3, die strukturierte Schicht 5 und zum Teil in die Kappe 1 hinein erstreckt.

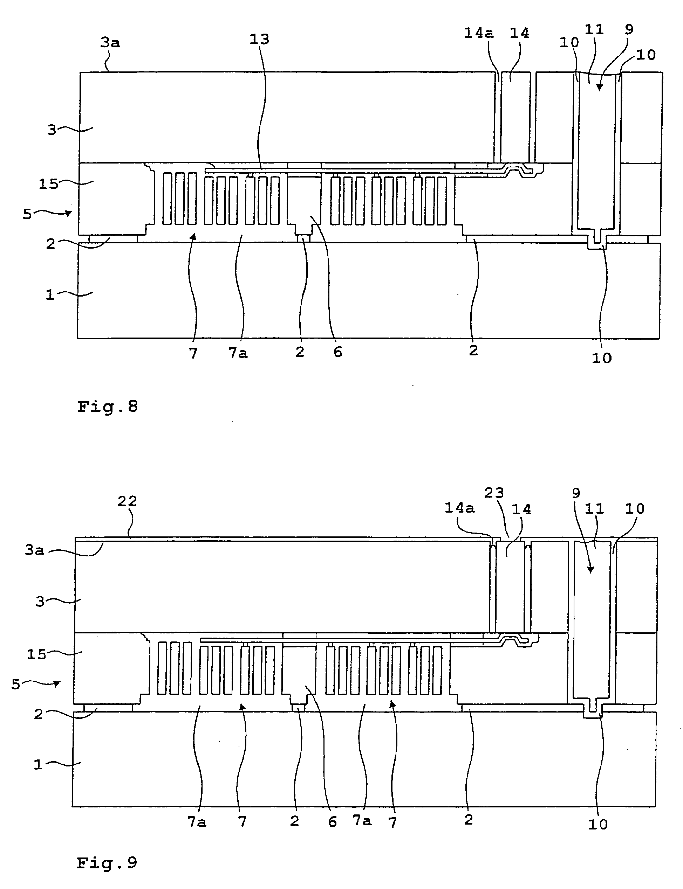

Wie in Fig. 7 dargestellt ist, wird die Leitschicht 10 auf die Bodenfläche und die Wandflächen 9a des Durchgangs 9 bzw. Sacklochs aufgebracht, indem sie auf der Rückseite 3a des Substrats 3 abgeschieden wird. Die Leitschicht 10, die vorzugsweise eine Metallschicht ist, stellt eine niederohmige Verbindung des Substrats 3 mit der Kappe 1 und der strukturierten Schicht 5 her. Anschließend wird in den Durchgang 9 bzw. das Sackloch eine Füllschicht 11 eingebracht, die den Durchgang 9 verschließt und die Oberflächentopographie einebnet. Bei der Füllschicht 11 handelt es sich bevorzugt um eine Silizium-Oxid-Schicht. Diese wird bevorzugt durch ein so genanntes Spin-On-Verfahren bzw. durch Einbringen und Aushärten eines Füllstoffs, der Silizium-Oxid enthält, hergestellt.

Mit einem Plasmaätzverfahren wird, wie in Fig. 8 gezeigt ist, die Füllschicht 11 rückgeätzt. Anschließend wird die Leitschicht 10 auf der Rückseite 3a des Substrats 3 nasschemisch entfernt. Dabei ist darauf zu achten, daß die Leitschicht 10 im Bereich der Gräben 14a vollständig entfernt wird und im Bereich des Durchgangs 9 nicht zu stark überätzt wird, damit sich keine unerwünschten Topographien ausbilden.

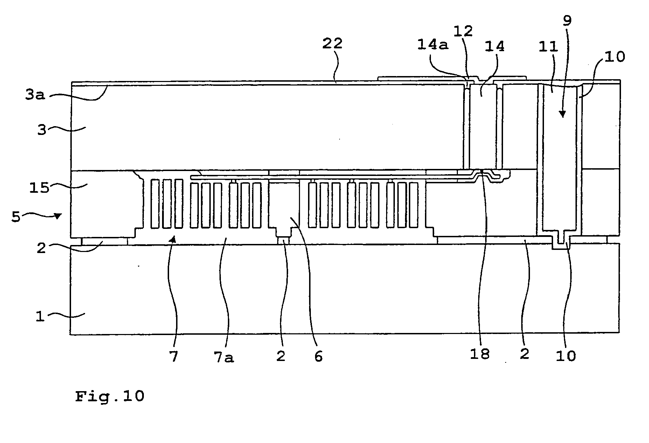

Entsprechend Fig. 9 wird die dielektrische Schicht 22 mit einem CVD-Verfahren auf die Rückseite 3a des Substrats 3 aufgebracht. Die dielektrische Schicht 22 dient als Isolationsschicht und isoliert die nachfolgend aufgebrachte Metallisierung 12 gegenüber dem Substrat 3. Im Bereich des Anschlussbereichs 14 ist in der dielektrischen Schicht 22 eine Kontaktöffnung 23 zur externen Kontaktierung des Anschlussbereichs 14 gebildet. Anschließend wird, wie in Fig. 10 dargestellt ist, die Metallisierung 12 auf die dielektrische Schicht 22 und über die Kontaktöffnung 23 auf den Anschlussbereich 14 aufgebracht und vorzugsweise nasschemisch zu einer Leiterbahn bzw. einem Anschluss wird strukturiert, wobei sich das Anschlusspad vorzugsweise in Richtung der Mitte des Bauelements erstreckt. Hierdurch lässt sich die zur Herstellung des Bauelements benötigte Substratfläche und dessen Volumen kostensparend verringern.

Beispielsweise ist es möglich, Sensor- bzw. Aktuator-Strukturen zusammen mit einer elektronischen Auswerteschaltung (nicht dargestellt) in die Kappe 1 und/oder in die strukturierte Schicht 5 zu integrieren.

Insgesamt zeichnet sich das oben beschriebene Bauelement durch ein kompaktes und robustes Design aus, das die Integration einer Vielzahl von Funktionsstrukturen und zugleich eine ausreichende Bewegungsfreiheit der Funktionsstrukturen gestattet.

Das oben beschriebene Verfahren ermöglicht die Herstellung einer Vielzahl von Bauelementen, die eine hermetisch dichte Verkappung erfordern. Der für die Verkappung bzw. die Verbindungsflächen benötigte ist dabei auf ein Minimum reduziert.

## Patentansprüche

1. Mikromechanisches Bauelement mit einem Substrat (3) und einer strukturierten Schicht (5), die zumindest auf einem Teil des Substrats (3) vorgesehen ist und zumindest teilweise von wenigstens einer Kappe (1) überdeckt ist, wobei zwischen der Kappe (1) und dem Substrat (3) eine leitende Verbindung (8) vorgesehen ist, die sich durch die strukturierte Schicht (5) hindurch erstreckt und insbesondere im Bereich einer Rahmenstruktur (15) der strukturierten Schicht (5) angeordnet ist, **dadurch gekennzeichnet, daß** die leitende Verbindung (8) durch einen Durchgang (9) bzw. ein Sackloch gebildet ist, auf dessen Bodenfläche und Wandflächen (9a) eine Leitschicht (10) aufgebracht ist, wobei der Durchgang (9) und/oder die Leitschicht (10) vorzugsweise mittels wenigstens einer Isolationsschicht (22) an der der strukturierten Schicht (5) abgewandten Seite (3a) des Substrats (3) abgedeckt ist/sind.

2. Mikromechanisches Bauelement nach Anspruch 1, **dadurch gekennzeichnet, daß** die Kappe (1), das Substrat (3) und die strukturierte Schicht (5) zumindest teilweise aus demselben Material, insbesondere aus Silizium hergestellt sind, wobei die Kappe (1) und das Substrat (3) vorzugsweise aus einkristallinem Silizium und die strukturierte Schicht (5) vorzugsweise aus polykristallinem Silizium hergestellt sind.

## Claims

1. Micromechanical component having a substrate (3) and a structured layer (5), which is provided at least on a part of the substrate (3) and is covered at least partly by at least one cap (1), a conductive connection (8) being provided between the cap (1) and the substrate (3), said conductive connection extending through the structured layer (5) and being arranged in particular in the region of a frame structure (15) of the structured layer (5), **characterized in that** the conductive connection (8) is formed by a passage (9) or a blind hole, on the bottom area and wall areas (9a) of which a conductive layer (10) is applied, the passage (9) and/or the conductive layer (10) preferably being covered by means of at least one insulation layer (22) at that side (3a) of the substrate (3) which is remote from the structured layer (5).

2. Micromechanical component according to Claim 1, **characterized in that** the cap (1), the substrate (3) and the structured layer (5) are produced at least partly from the same material, in particular from silicon, the cap (1) and substrate (3) preferably being produced from monocrystalline silicon and the structured layer (5) preferably being produced from polycrystalline silicon.

## Revendications

1. Composant micromécanique comportant un substrat (3) et une couche (5) mise en structure, prévu au moins sur une partie du substrat (3) et couverte au moins en partie par au moins un capot (1) et entre le capot (1) et le substrat (3), une liaison conductrice (8) traverse la couche structurée (5) et se trouve notamment au niveau de la structure d'encadrement (15) de la couche structurée (5),
**caractérisé en ce que**
la liaison conductrice (8) est formée par un passage (9) ou un perçage borgne dont la surface du fond et la surface des parois (9a) portent une couche conductrice (10), le passage (9) et/ou la couche conductrice (10) étant couverts de préférence par au moins une couche d'isolation (22) sur la face (3a) du substrat (3) à l'opposé de la couche structurée (5).

2. Composant micromécanique selon la revendication 1
**caractérisé en ce que**
le capot (2), le substrat (3) et la couche structurée (5) sont au moins en partie réalisés dans le même matériau, notamment en silicium et le capot (1) et le substrat (3) sont fabriqués de préférence dans un silicium mono-cristallin et la couche structurée (5), de préférence dans un silicium poly-cristallin.
